(19) Europäisches Patentamt / European Patent Office / Office européen des brevets

(11) **EP 4 137 829 B1**

(12) **EUROPEAN PATENT SPECIFICATION**

(45) Date of publication and mention
of the grant of the patent:
**27.08.2025 Bulletin 2025/35**

(21) Application number: **21845332.2**

(22) Date of filing: **23.07.2021**

(51) International Patent Classification (IPC):
*G01R 31/382* (2019.01)    *G01R 31/367* (2019.01)
*G01R 31/396* (2019.01)    *G01R 31/3835* (2019.01)
*G01R 31/392* (2019.01)    *H02J 7/00* (2006.01)
*G01R 19/165* (2006.01)

(52) Cooperative Patent Classification (CPC):
**G01R 31/367; G01R 31/3835; G01R 31/392;**
**G01R 31/396; H02J 7/0047;** G01R 19/16542;
Y02E 60/10

(86) International application number:
**PCT/KR2021/009542**

(87) International publication number:
**WO 2022/019703 (27.01.2022 Gazette 2022/04)**

(54) **DEVICE AND METHOD FOR DIAGNOSING BATTERY**

VORRICHTUNG UND VERFAHREN ZUR BATTERIEDIAGNOSE

DISPOSITIF ET PROCÉDÉ DE DIAGNOSTIC DE BATTERIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **23.07.2020 KR 20200091936**

(43) Date of publication of application:
**22.02.2023 Bulletin 2023/08**

(73) Proprietor: LG Energy Solution, Ltd.
**Seoul 07335 (KR)**

(72) Inventor: **LIM, Bo Mi**
**Daejeon 34122 (KR)**

(74) Representative: **Plasseraud IP**
**104 Rue de Richelieu**
**CS92104**
**75080 Paris Cedex 02 (FR)**

(56) References cited:
JP-A- 2003 059 544    JP-A- 2008 256 436
JP-A- 2010 014 636    JP-A- 2014 167 450
KR-B1- 100 534 818    US-A1- 2020 191 876

# Description

## [TECHNICAL FIELD]

### Cross-reference to Related Applications

This application claims the benefit of Korean Patent Application No. 10-2020-0091936, filed on July 23, 2020, in the Korean Intellectual Property Office.

### Technical Field

The present invention relates to a device for diagnosing a battery, and more particularly, to a device for diagnosing a type of an error occurring in a battery cell based on a voltage of the battery cell.

## [BACKGROUND ART]

Recently, research and development on secondary batteries has been actively carried out. Here, the secondary battery is a battery capable of charging and discharging, and includes all of a conventional Ni/Cd battery, a Ni/MH battery, and a recent lithium ion battery. Among secondary batteries, lithium ion batteries have an advantage in that their energy density is much higher than that of conventional Ni/Cd batteries and Ni/MH batteries. Lithium-ion batteries may be manufactured to be small and lightweight, and are used as power sources for mobile devices. In particular, a lithium ion battery may be used as a power source for an electric vehicle, and thus attracts attention as a next-generation energy storage medium.

In addition, the secondary battery is generally used as a battery pack including a battery module in which a plurality of battery cells are connected in series and/or in parallel. The state and operation of the battery pack are managed and controlled by the battery management system. Battery cells in the battery pack are charged by receiving power from the outside.

The charged battery cells supply power to various devices and/or circuits connected to the battery pack. When an error occurs in a battery cell, fatal damage may occur to not only the battery, but also a vehicle, an electronic device, and the like including the battery. Therefore, it is important to diagnose what type of error occurs in the battery cell and take appropriate measures accordingly. US2020/191876 A1 relates to a user-level SoH estimation service for mobile devices based only on their battery voltage, which is already available on all commodity mobile devices. The design of the estimation service is inspired by an empirical observation that the relaxing voltages of a device battery fingerprint its SoH. It also illustrates a system for delivering battery services in a mobile device, such as a phone. The mobile device includes a rechargeable battery, a measurement circuit and one or more controllers.The measurement circuit is configured to measure the voltage of the battery and/or cells which comprise the battery. A health estimator is implemented by the one or more controllers. The health estimator is configured to receive voltage measurements for the battery and estimate the state-of-health of the battery.

## [DISCLOSURE OF THE INVENTION]

## [TECHNICAL PROBLEM]

The present invention has been made to solve the above technical problem, and an object of the present invention is to provide a battery diagnosis device for diagnosing a type of error occurring in a battery cell based on the voltage of the battery cell.

## [TECHNICAL SOLUTION]

A battery diagnosis device according to an embodiment of the present invention includes a voltage measurement circuit, a data processing circuit and a diagnosis circuit. The voltage measurement circuit periodically measures the voltage at both ends of the battery cell in the rest section. The data processing circuit derives a statistical value indicating the state of the battery cell based on difference values between the voltage values measured by the voltage measurement circuit and fitting values calculated based on the measured voltage values. The diagnosis circuit determines whether an error has occurred in the battery cell based on the statistical values in the plurality of rest sections, and determine whether the type of error is a first type in which the battery cell is unstable, a second type in which the voltage of the battery cell temporarily rises, or a third type in which the voltage of the battery cell temporarily drops based on a cumulative statistical value in which absolute values of the statistical values are accumulated and the statistical value in the rest section. The plurality of rest sections include a rest section and one or more rest sections before the rest section.

A battery diagnosing method according to an embodiment of the present invention includes: a first step of periodically measuring a voltage at both ends of a battery cell in a rest section by a battery diagnosis device; a second step of calculating a statistical value representing a state of the battery cell based on difference values between voltage values measured by the battery diagnosis device and fitting values calculated based on the measured voltage values; a third step of determining whether an error has occurred in the battery cell based on the statistical values in the plurality of rest sections; and a fourth step of diagnosing the type of error based on a first comparison result of comparing a cumulative statistical value accumulated with absolute values of the statistical values with a first analysis reference value, and a second comparison result of comparing the statistical value with a second analysis reference value. The plurality of rest sections include the rest section and one or more rest sections before the rest section.

**[EFFECTS OF THE INVENTION]**

The battery diagnosis device according to an embodiment of the present invention determines a change in the voltage of the battery cell by periodically measuring the voltage of the battery cell. The battery diagnosis device determines the type of error occurring in the battery cell according to the transition of the voltage of the battery cell. Therefore, the battery diagnosis device can take appropriate measures for the battery cells.

**[BRIEF DESCRIPTION OF THE DRAWINGS]**

FIG. 1 is a block diagram showing the configuration of a battery control system.

FIG. 2 is a block diagram showing the configuration of the battery pack 10 including the battery diagnosis device of the present invention.

FIG. 3 is a flowchart for explaining the operation of the battery management system 200 of FIG. 2.

FIG. 4A is a graph showing a voltage and a fitting value of the battery cell B1 of FIG. 2 in a rest section after charging.

FIG. 4B is a graph showing a voltage and a fitting value of the battery cell B1 of FIG. 2 in a rest section after discharging.

FIG. 5 is a flowchart for explaining an operation in which the battery management system 200 of FIG. 2 determines whether an abnormal voltage phenomenon has occurred in the battery cell B1.

FIG. 6 is a flowchart illustrating an operation of diagnosing a type of an abnormal voltage phenomenon occurring in the battery cell B1 by the battery management system 200 of FIG. 2.

FIG. 7A is a graph illustrating a case in which the voltage of the battery cell B1 falls in the rest section after charging.

FIG. 7B is a graph showing a case in which the voltage of the battery cell B1 falls in the rest section after discharging.

FIG. 8A is a graph illustrating a case in which the voltage of the battery cell B1 increases in the rest section after charging.

FIG. 8B is a graph illustrating a case in which the voltage of the battery cell B1 increases in the rest section after discharging.

FIG. 9A is a graph illustrating a case in which the battery cell B1 is unstable in the rest section after charging.

FIG. 9B is a graph showing a case in which the battery cell B1 is unstable in the rest section after discharging.

FIG. 10 is a diagram illustrating a hardware configuration of a battery diagnosis device according to an embodiment of the present invention.

**[MODE FOR CARRYING OUT THE INVENTION]**

Hereinafter, various embodiments of the present invention will be described in detail with reference to the accompanying drawings. In this document, the same reference numerals are used for the same components in the drawings, and duplicate descriptions of the same components are omitted.

For the various embodiments of the present invention disclosed in this document, specific structural or functional descriptions have been exemplified for the purpose of describing the embodiments of the present invention only and various embodiments of the present invention may be implemented in various forms and should not be construed as being limited to the embodiments described in this document.

Expressions such as "first", "second", "first", or "second" used in various embodiments may modify various elements regardless of their order and/or importance, and do not limit the corresponding elements. For example, without departing from the scope of the present invention, a first component may be referred to as a second component, and similarly, a second component may be renamed and referred to as a first component.

Terms used in this document are only used to describe a specific embodiment, and may not be intended to limit the scope of other embodiments. The terms of a singular form may include plural forms unless otherwise specified.

All terms used herein, including technical or scientific terms, may have the same meaning as commonly understood by a person of ordinary skill in the art. Terms defined in a commonly used dictionary may be interpreted as having the same or similar meaning as the meaning in the context of the related technology, and are not interpreted as ideal or excessively formal meanings unless explicitly defined in this document. In some cases, even terms defined in this document cannot be interpreted to exclude embodiments of the present invention.

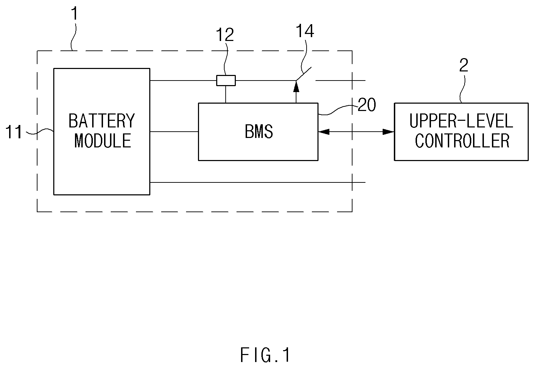

FIG. 1 is a block diagram showing the configuration of a battery control system.

Referring to FIG. 1, it schematically shows a battery control system including a battery pack 1 and an upper-level controller 2 included in an upper-level system according to an embodiment of the present invention.

As shown in FIG. 1, the battery pack 1 includes a battery module 11 consisting of one or more battery cells and capable of charging and discharging, a switching unit 14 connected in series to the + terminal side or the - terminal side of the battery module 11 to control the charge/discharge current flow of the battery module 11, and a battery management system 20 for controlling and managing the voltage, current, temperature, and the like of the battery pack 1 to prevent overcharging and overdischarging.

Here, the switching unit 14 is a switching element for controlling the current flow for charging or discharging of the battery module 11, and for example, a semiconductor switching element such as at least one MOSFET or a relay may be used.

In addition, the battery management system 20 may monitor the voltage, current, temperature, etc. of the battery pack 1, and also, may measure the current, voltage, temperature, etc. of the battery pack using the sensor 12 provided adjacent to the switching unit 14. The battery management system 20 is an interface for receiving values obtained by measuring the above-described various parameters, and may include a plurality of terminals and a circuit connected to these terminals to process input values.

In addition, the battery management system 20 may control ON/OFF of the switching unit 14, for example, a MOSFET or a relay, and may be connected to the battery module 11 to monitor the state of the battery module 11.

The upper-level controller 2 may transmit a control signal for the battery module 11 to the battery management system 20. Accordingly, the operation of the battery management system 20 may be controlled based on a signal applied from the upper-level controller 2. The battery cell of the present invention may be included in a battery pack used for an Energy Storage System (ESS) or a vehicle. However, it is not limited to these uses.

Since the configuration of the battery pack 1 and the configuration of the battery management system 20 are known configurations, a more detailed description thereof will be omitted.

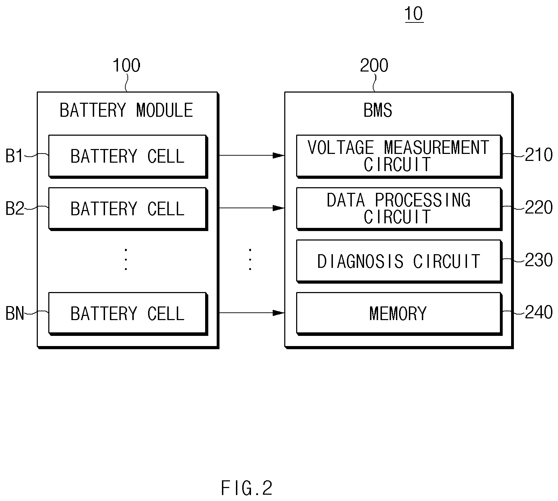

FIG. 2 is a block diagram showing the configuration of the battery pack 10 including the battery diagnosis device of the present invention. The battery module 100 and the battery management system 200 of FIG. 2 may correspond to the battery module 11 and the battery management system 20 of FIG. 1.

The battery pack 10 may include a battery module 100 and a battery management system 200. The "battery diagnosis device" of the present invention may be a device including some or all components of the battery management system 200. By way of example, a "battery diagnosis device" may include a voltage measurement circuit 210, a data processing circuit 220, a diagnosis circuit 230, and a memory 240.

The battery module 100 may include a plurality of battery cells B1 to BN. The plurality of battery cells B1 to BN may be configured to be connected in series and/or in parallel. Referring to FIG. 2, the battery pack 1 is illustrated as including one battery module 100, but the present invention is not limited thereto, and the battery pack 10 may include one or more battery modules.

In the charging section, the battery module 100 may receive power from a power supply device (not shown). In the charging section, the voltage at both ends of each of the battery cells B1 to BN may increase. In the following descriptions, "voltage of a battery cell" means "voltage at both ends of a battery cell". In the discharging section, the battery module 100 may supply power to external devices and/or circuits. There may be a rest section between the charging section and the discharging section. In the rest section, the battery module 100 may stop an operation of receiving power or supplying power. When the battery module 100 is included in the electric vehicle, external devices and/or circuits may be a motor, a power control unit (PCU), an inverter, or the like.

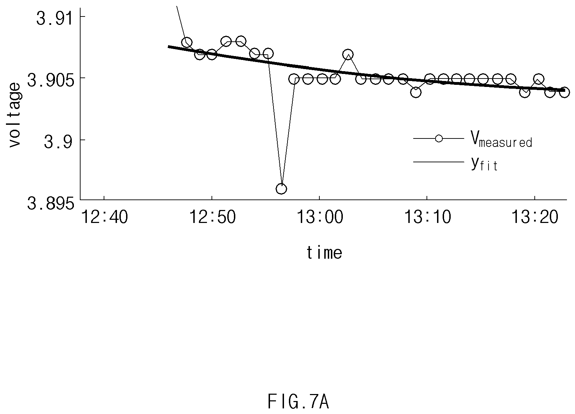

If no error occurs in the battery cell, in the rest section after charging, the voltage of the battery cell gradually decreases and then remains in a state slightly lower than the voltage at the time point when charging is completed. Also, when no error occurs in the battery cell, in the rest section after discharging, the voltage of the battery cell is gradually increased and then maintained in a slightly increased state than the voltage at the time point when the discharging is completed. However, when an error occurs in the battery cell, a peak section in which the voltage of the battery cell abruptly increases or decreases occurs in the rest section, or the voltage of the battery cell continues to increase or decrease without being maintained at a constant value. In the following descriptions, the abnormal voltage phenomenon means that, in the rest section, a peak section in which the voltage of the battery cell abruptly increases or decreases occurs, or the voltage of the battery cell continues to increase or decrease without being maintained at a constant value. The abnormal voltage phenomenon will be described in detail with reference to FIGS. 7A to 9B. The battery management system 200 of the present invention may monitor the battery cells B1 to BN to determine whether an abnormal voltage phenomenon has occurred in the battery cells B1 to BN and the type of the abnormal voltage phenomenon.

The battery management system 200 may include a voltage measurement circuit 210, a data processing circuit 220, a diagnosis circuit 230, and a memory 240. The battery management system 200 may more accurately determine whether an abnormal voltage phenomenon has occurred in the battery cells B1 to BN through the absolute determination operation, the relative determination operation, and the accumulation determination operation. In the following descriptions, checking whether an error occurs in the battery cell B1 means checking whether an abnormal voltage phenomenon occurs in the battery cell B1.

After checking whether an abnormal voltage phenomenon occurs in the battery cell B1, the battery management system 200 may diagnose the type of the abnormal voltage phenomenon through a voltage analysis operation of the battery cell B1. In the following descriptions, diagnosing the type of error occurring in the battery cell B1 means diagnosing the type of the abnormal voltage phenomenon occurring in the battery cell B1.

In addition, in the following descriptions, for convenience of description, a method of the battery management system 200 to check the battery cell B1 is intensively described. The battery management system 200 may also check the remaining battery cells B2 to BN in the same manner as the method for checking the battery cell B1.

First, a method of the battery management system 200 to perform an absolute determination operation is described. In this specification, the absolute determination operation, the relative determination operation, the cumulative determination operation, and the voltage analysis operation are performed based on the voltage of the battery cell B1 in the rest section.

Hereinafter, the absolute determination operation will be described. The voltage measurement circuit 210 may measure the voltage of the battery cell B1 in the rest section. The voltage measurement circuit 210 may output voltage data for the measured voltage to the data processing circuit 220.

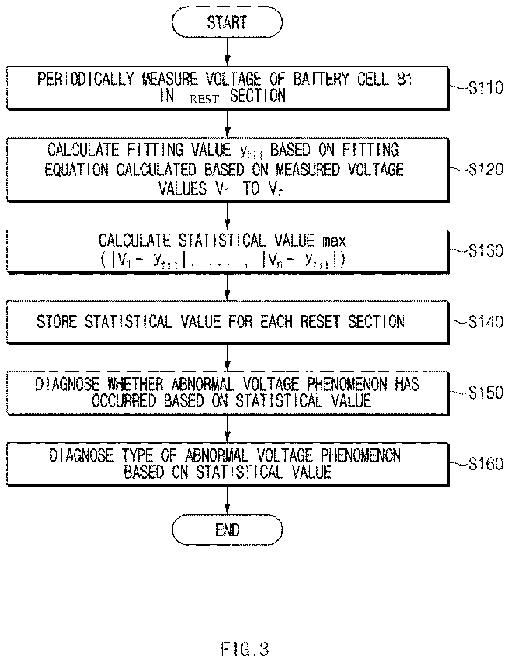

The data processing circuit 220 may process the voltage data received from the voltage measurement circuit 210 to calculate absolute statistical values. The absolute statistical value may be a value calculated by substituting voltage data into a voltage fitting equation. The absolute statistical value is described in detail with reference to FIG. 3.

The diagnosis circuit 230 may receive information on an absolute statistical value. The diagnosis circuit 230 may determine whether the absolute statistical value satisfies the absolute determination condition. The absolute determination condition may mean that the absolute statistical value is greater than the first absolute reference value and less than or equal to the second absolute reference value. The first absolute reference value may be a value related to an error tolerance range of the absolute value, and the second absolute reference value may be a value related to a fatal error that may occur in the battery cell B1. For example, the first absolute reference value may be 10 [mV], and the second absolute reference value may be 250 [mV]. The first and second absolute reference values may be values set by a user. However, the present invention is not limited thereto, and the first and second absolute reference values may be values determined based on the state of the battery cell B1, such as the temperature of the battery cell B1 and the SOC of the battery cell B1.

Second, a method of the battery management system 200 to perform the relative determination operation is described.

Hereinafter, the relative determination operation will be described. The voltage measurement circuit 210 may measure the voltage of each of the battery cells B1 to BN in the rest section. The voltage measurement circuit 210 may output voltage data for the measured voltages to the data processing circuit 220.

The data processing circuit 220 may process the voltage data received from the voltage measurement circuit 210 to calculate a relative reference value. Specifically, the data processing circuit 220 may calculate the absolute statistical values of the battery cells B1 to BN in the same manner as the method of calculating the absolute statistical value of the battery cell B1 in the absolute determination operation. The data processing circuit 220 may determine the relative reference value based on the 'k' sigma value of the absolute statistical values of the battery cells B1 to BN. Here, 'k' may be a positive number. As an example, the relative reference value may be the +3 sigma value of absolute statistical values. As another example, the relative reference value may be the +6 sigma value of absolute statistical values.

The diagnosis circuit 230 may receive information on the absolute statistical value and the relative reference value of the battery cell B1. The diagnosis circuit 230 may determine whether an error has occurred in the battery cell B1 by comparing the absolute statistical value with the relative reference value.

Next, a method of the battery management system 200 to perform the accumulation determination operation will be described. The battery management system 200 may perform an absolute determination operation and a relative determination operation at regular intervals during the analysis period. Using data generated in the absolute determination operation and the relative determination operation, the battery management system 200 may perform a cumulative determination operation.

The battery management system 200 may perform a cumulative determination operation using absolute statistical values and actual statistical values of a plurality of rest sections. In the present specification, the plurality of rest sections may include a rest section that is the target of an absolute determination operation and one or more rest sections before the rest section.

The data processing circuit 220 may calculate a standard deviation value of actual statistical values regarding the voltage of the battery cell B1. The absolute statistical value is a value obtained by superimposing an absolute value on a statistical value calculated based on the voltage of the battery cell B1, and actual statistical values refer to statistical values. In the following descriptions, the standard deviation value means the standard deviation of actual statistical values with respect to the voltage of the battery cell B1 calculated during the analysis period. The diagnosis circuit 230 may receive information on a standard deviation value and a reference deviation value. The diagnosis circuit 230 may compare the standard deviation value with the reference deviation value. The reference deviation value may be a value previously determined by a user, or a value determined by the voltage, temperature, etc. of the battery cell B1.

The data processing circuit 220 may calculate a cumulative statistical value by accumulating absolute statistical values regarding the voltage of the battery cell B1. For example, the data processing circuit 220 may calculate a cumulative statistical value by accumulating all absolute statistical values calculated during the analysis period. As another example, the data processing circuit 220 may calculate a cumulative statistical value by selecting some of the absolute statistical values calculated during the analysis period, and accumulating the selected absolute statistical values. Specifically, the data processing circuit 220 may calculate a cumulative statistical value by accumulating absolute statistical values obtained at a specific time during the analysis period.

The data processing circuit 220 may calculate the cumulative reference value by accumulating relative reference values in a similar way to calculating the cumulative statistical value. However, the present invention is not limited thereto, and the data processing circuit 220 may calculate the cumulative reference value based on the absolute reference value. Also, the cumulative reference value may be a value set by a user.

The diagnosis circuit 230 may receive information on the cumulative statistical value and the cumulative reference value. The diagnosis circuit 230 may compare the cumulative statistical value with the cumulative reference value. The diagnosis circuit 230 may determine whether an error has occurred in the battery cell B1 by comparing the standard deviation value with the reference deviation value and comparing the cumulative statistical value with the cumulative reference value.

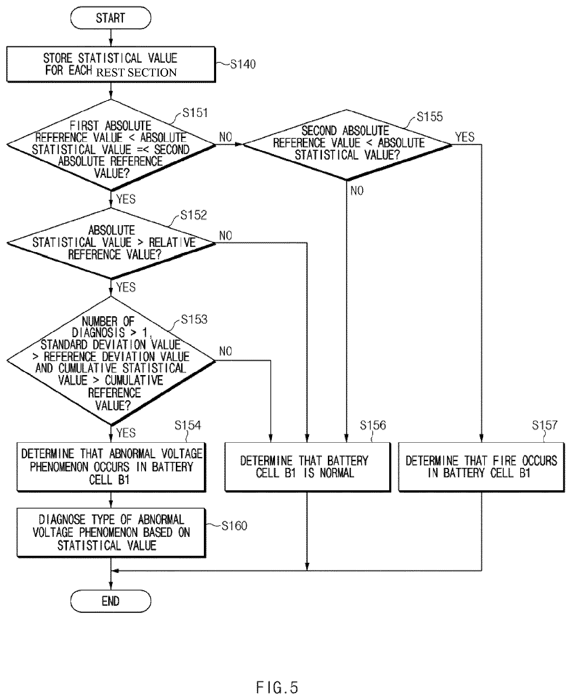

The diagnosis circuit 230 may finally determine whether an error has occurred in the battery cell B1 based on the absolute determination operation, the relative determination operation, and the cumulative determination operation. Contents related thereto will be described in detail with reference to FIG. 5.

The diagnosis circuit 230 may perform a voltage analysis operation on the battery cell B1 determined to have an error. The diagnosis circuit 230 may diagnose the type of error through the voltage analysis operation.

Below, the voltage analysis operation is described. The diagnosis circuit 230 may compare the cumulative statistical value with the first analysis reference value. The diagnosis circuit 230 may diagnose that the type of the abnormal voltage phenomenon is the unstable type of the battery cell B1 when the cumulative statistical value is greater than the first analysis reference value. The first analysis reference value may be related to the voltage of the battery cell B1 in the rest section. The first analysis reference value may be a relatively large value. That is, the fact that the cumulative statistical value of the battery cell B1 is greater than the first analysis reference value means that the voltage of the battery cell B1 is relatively severely shaken.

The diagnosis circuit 230 may compare the absolute statistical value of the battery cell B1 with the second reference analysis value when the cumulative statistical value is equal to or less than the first analysis reference value. For example, the second reference analysis value may be '0'. When the absolute statistical value is greater than the second reference analysis value, the diagnosis circuit 230 may diagnose that the type of the abnormal voltage phenomenon is the type in which the voltage of the battery cell B1 is increased. The diagnosis circuit 230 may diagnose that the type of the abnormal voltage phenomenon is the type in which the voltage of the battery cell B1 has dropped when the absolute statistical value is equal to or less than the second reference analysis value.

FIG. 3 is a flowchart for explaining the operation of the battery management system 200 of FIG. 2.

In operation S110, the voltage measurement circuit 210 periodically measures the voltage of the battery cell B1 in one rest section. Voltage values of the battery cell B1 measured in one rest section are expressed as measured voltage values V1 to Vn. However, in the present invention, the number of measured voltage values is not limited to n.

The battery pack 10 of FIG. 2 may repeat a charge/discharge cycle, and may perform a charge/discharge operation. The charge/discharge cycle may be composed of a charging section, a rest section after charging, a discharging section, and a rest section after discharging. In this specification, one rest section means a section from the section where the charging section ends to the section before the discharging section starts (rest section after charging), or a section from the section where the discharging section ends to the section before the rest section starts (rest section after discharging).

In operation S120, the data processing circuit 220 calculates a fitting equation for the voltage of the battery cell B1 based on the measured voltage values V1 to Vn. In this case, the fitting equation calculated by the data processing circuit 220 may be a model voltage representing the voltage shape of the battery cell B1. For example, the fitting equation may be an expression related to an exponential. Also, the data processing circuit 220 may calculate the fitting equation by least squares estimation. However, this is merely exemplary, and the present invention is not limited thereto, and the data processing circuit 220 may calculate the fitting equation in various ways.

The fitting equation of the battery voltage is derived through least square estimation. At this time, the fitting equation of the battery voltage can be expressed as in [Equation 1].

$$[\text{Equation 1}]$$

$$y_{fit} = a \times \exp(b \cdot t) + c$$

In the battery diagnosis device according to an embodiment of the present invention, the fitting equation of the battery voltage can be completed by calculating the constants of a, b, and c in [Equation 1], respectively. In the following descriptions, yfit of [Equation 1] is expressed as a fitting value. [Equation 1] is only shown as an example, and the present invention is not limited thereto, and various equations capable of fitting the voltage of the battery may be used.

In operation S130, the data processing circuit 220 determines a statistical value based on the difference values V1-yfit1, ..., Vn-yfitn between the measured voltage values V1 to Vn and the fitting value yfit. The statistical value may be a difference value having the largest absolute value among the difference values V1-yfit1, ... , Vn-yfitn. In the following descriptions, absolute statistical value max(|V1-yfit1|, ... , |Vn-yfitn|) means the absolute value of the statistical value. Actual statistical values refer to statistical values. That is, if the absolute statistical value is |Vk-yfitk|, the actual statistical value is Vk-yfitk.

In operation S140, the data processing circuit 220 calculates statistical values for each rest section. The memory 240 may store statistical values for each rest section.

In operation S150, the diagnosis circuit 230 may diagnose whether an abnormal voltage phenomenon has occurred in the battery cell B1 based on the statistical value. The operation is described in more detail with reference to FIG. 5.

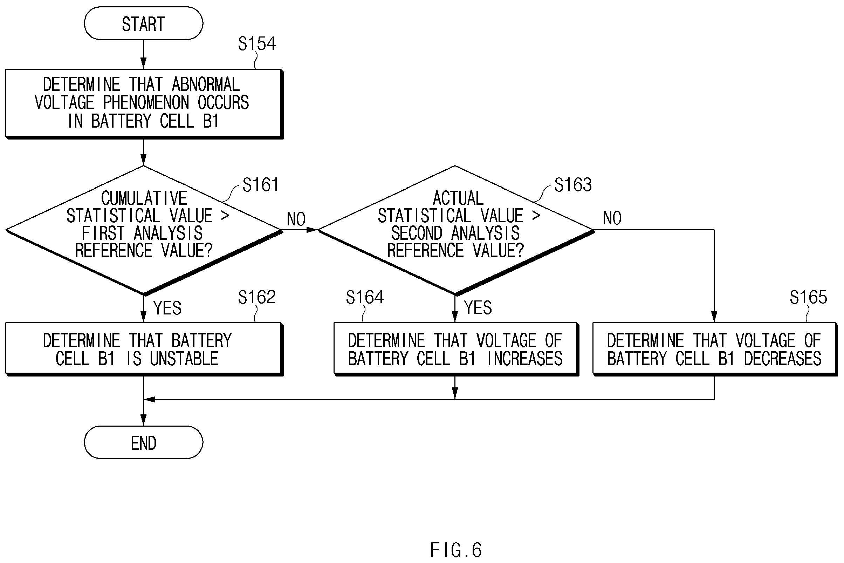

In operation S160, the diagnosis circuit 230 diagnoses the type of the abnormal voltage phenomenon occurring in the battery cell B1 based on the statistical value. The operation is described in more detail with reference to FIG. 6.

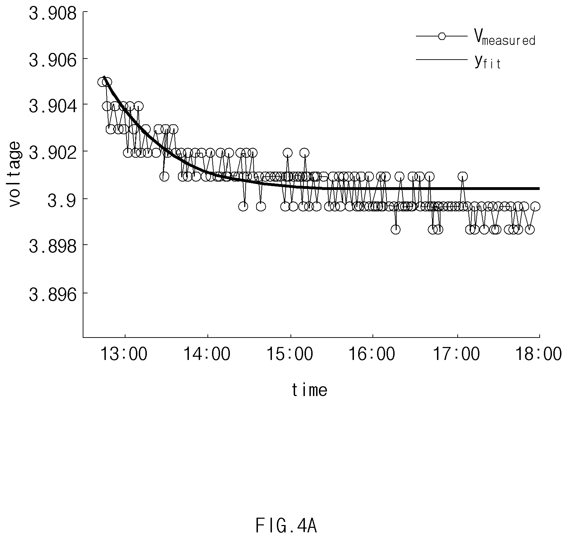

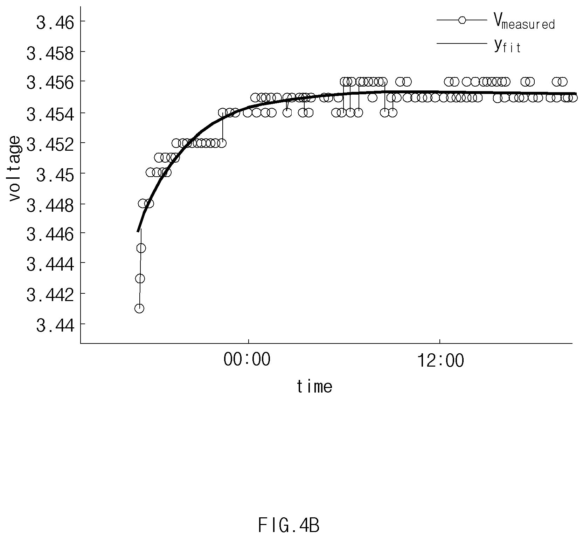

FIG. 4A is a graph showing a voltage and a fitting value of the battery cell B1 of FIG. 2 in a rest section after charging. FIG. 4B is a graph showing a voltage and a fitting value of the battery cell B1 of FIG. 2 in a rest section after discharging. In order to facilitate understanding of the present invention, reference is made to FIGS. 4A and 4B together.

The voltage Vmeasured of the battery cell B1 shown in FIGS. 4A and 4B represents a voltage when no error occurs in the battery cell B1.

FIG. 4A shows a voltage Vmeasured and a fitting value yfit of the battery cell B1 of FIG. 2 in the rest section after charging. In FIG. 4A, the horizontal axis represents time (hours), and the vertical axis represents voltage (V). Referring to FIG. 4A, in the rest section after charging, the voltage Vmeasured of the battery cell B1 is gradually decreased and maintained at a specific voltage value. In this case, the specific voltage value may be slightly lower than the voltage at the time point when the charging is completed.

FIG. 4B shows the voltage Vmeasured and the fitting value yfit of the battery cell B1 in the rest section after discharging. In FIG. 4B, the horizontal axis represents time (hours), and the vertical axis represents voltage (V). Referring to FIG. 4B, in the rest section after discharging, the voltage Vmeasured of the battery cell B1 is gradually increased and maintained at a specific voltage value. In this case, the specific voltage value may be slightly higher than the voltage at the time point when the charging is completed.

FIG. 5 is a flowchart for explaining an operation in which the battery management system 200 of FIG. 2 determines whether an abnormal voltage phenomenon has occurred in the battery cell B1.

Operations S151 to S157 described with reference to FIG. 5 are included in operation S150 described with reference to FIG. 3. That is, through operation S151 to operation S157, the diagnosis circuit 230 may diagnose whether an abnormal voltage phenomenon has occurred in the battery cell B1 based on the statistical value.

In operation S140, the data processing circuit 220 may calculate statistical values for each rest section. The memory 240 may store absolute statistical values and actual statistical values for each rest section.

In operation S151, the diagnosis circuit 230 may determine whether the absolute statistical value of the battery cell B1 satisfies the absolute determination condition. The absolute determination condition may mean that the absolute statistical value is greater than the first absolute reference value and less than or equal to the second absolute reference value. For example, the first absolute reference value may be 10 [mV], and the second absolute reference value may be 250 [mV].

If the absolute statistical value satisfies the absolute determination condition, operation S152 is performed. In operation S152, the diagnosis circuit 230 may compare the absolute statistical value with a relative reference value. The relative reference value may be a 'k' sigma value of the absolute statistical values of the battery cells B1 to BN. As an example, the relative reference value may be the +6 sigma value of absolute statistical values.

When the absolute statistical value is greater than the relative reference value, operation S153 is performed. In operation S153, the diagnosis circuit 230 may compare a standard deviation value of the battery cell B1 with a reference deviation value, and may compare a cumulative statistical value of the battery cell B1 with a cumulative reference value. For example, the reference deviation value may be 0.5, but the present invention is not limited thereto. For example, when absolute statistical values of rest sections are Vmax(1) to Vmax(p), the cumulative statistical value may be $\sum_{i=1}^{p} V_{max}(i)$.

Also, the cumulative reference value may be a value corresponding to the top 5% among the cumulative statistical values of the battery cells B1 to BN.

When the standard deviation value of the battery cell B1 is greater than the reference deviation value and the cumulative statistical value of the battery cell B1 is greater than the cumulative reference value, operation S154 is performed. In operation S154, the diagnosis circuit 230 may determine that an abnormal voltage phenomenon has occurred in the battery cell B1. In this case, in operation S160, the diagnosis circuit 230 may diagnose the type of the abnormal voltage phenomenon occurring in the battery cell B1. Operation S160 will be described in detail with reference to FIG. 6.

If the absolute statistical value does not satisfy the absolute determination condition, operation S155 is performed. In operation S155, the diagnosis circuit 230 may compare the absolute statistical value with a second absolute reference value. However, the order in which the battery management system 200 performs operations S151 to S155 is not limited to the order described with reference to FIG. 5. The battery management system 200 may perform operation S152 before operation S151, and may perform operation S153 before operation S152.

When the absolute statistical value is smaller than the second absolute reference value, operation S156 is performed. When the absolute statistical value is equal to or less than the relative reference value, operation S156 is performed. Also, when the standard deviation value of the battery cell B1 is equal to or less than the reference deviation value or the cumulative statistical value of the battery cell B1 is equal to or less than the accumulated reference value, operation S156 is performed. In operation S156, the diagnosis circuit 230 may determine that the battery cell B1 is normal.

In addition, when the absolute statistical value is equal to or greater than the second absolute reference value, operation S157 is performed. In operation S157, the diagnosis circuit 230 may determine that a fire has occurred in the battery cell B1. Alternatively, the diagnosis circuit 230 may determine that a fatal error has occurred in the battery cell B1. The second absolute reference value may be a relatively large value. Accordingly, the fact that the absolute statistical value is greater than or equal to the second absolute reference value may mean that a more fatal error has occurred in the battery cell B1. The battery management system 200 may take appropriate measures to prevent damage based on the determination result.

FIG. 6 is a flowchart illustrating an operation of diagnosing a type of an abnormal voltage phenomenon occurring in the battery cell B1 by the battery management system 200 of FIG. 2.

Operations S161 to S165 described with reference to FIG. 6 are included in operation S160 described with reference to FIG. 3. That is, through operations S161 to S165, the diagnosis circuit 230 may determine the type of the abnormal voltage phenomenon occurring in the battery cell B1 based on the statistical value. Operations S161 to S165 are performed only with respect to the battery cell in which the abnormal voltage phenomenon is determined to have occurred in operation S150. In the following descriptions, it is assumed that an abnormal voltage phenomenon occurs in the battery cell B1.

In operation S154, the diagnosis circuit 230 may determine that an abnormal voltage phenomenon has occurred in the battery cell B1.

In operation S161, the diagnosis circuit 230 may compare the cumulative statistical value of the battery cell B1 with the first analysis reference value.

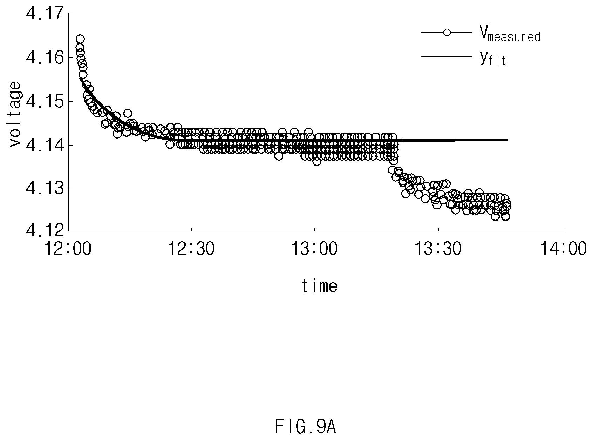

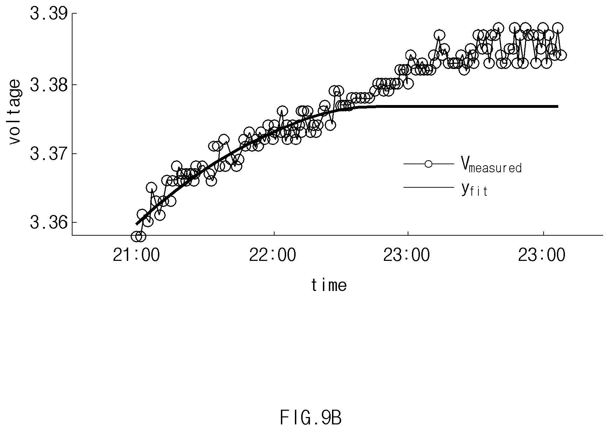

When the cumulative statistical value is greater than the first analysis reference value, operation S162 is performed. In operation S162, the diagnosis circuit 230 may diagnose that the type of the abnormal voltage phenomenon is an unstable type of the battery cell B1. The first analysis reference value may be a relatively large value. For example, the first analysis reference value may be 250 [mV]. That is, the fact that the cumulative statistical value of the battery cell B1 is greater than the first analysis reference value means that the voltage of the battery cell B1 is relatively severely shaken. The type of the abnormal voltage phenomenon is described with reference to FIGS. 9(a) and 9(b).

When the cumulative statistical value is less than or equal to the first analysis reference value, operation S163 is performed. In operation S163, the diagnosis circuit 230 may compare the actual statistical value of the battery cell B1 with the second analysis reference value. For example, the second analysis reference value may be 0 [mV]. However, the order in which the battery management system 200 performs operation S161 and operation S163 is not limited to the order described with reference to FIG. 6. For example, the battery management system 200 may perform operation S163 before operation S161.

When the actual statistical value is greater than the second analysis reference value, operation S164 is performed. In operation S164, the diagnosis circuit 230 may determine that the voltage of the battery cell B1 is increased as the type of the abnormal voltage phenomenon.

When the actual statistical value is less than or equal to the second analysis reference value, operation S165 is performed. In operation S165, the diagnosis circuit 230 may determine that the voltage of the battery cell B1 has dropped as the type of the abnormal voltage phenomenon.

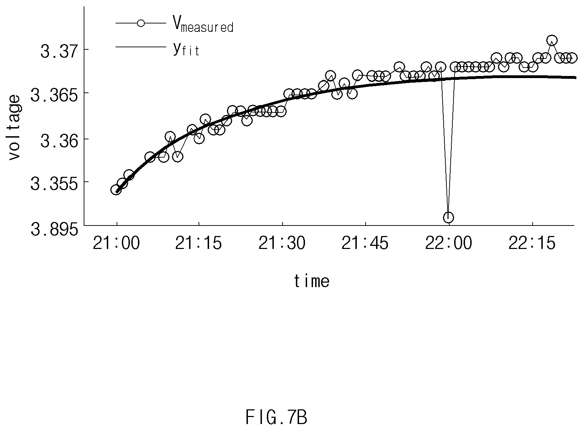

FIG. 7A is a graph illustrating a case in which the voltage of the battery cell B1 falls in the rest section after charging. FIG. 7B is a graph showing a case in which the voltage of the battery cell B1 falls in the rest section after discharging. For convenience of description, FIGS. 7A and 7B are referred to together.

FIG. 7A illustrates a case in which an abnormal voltage phenomenon in which the voltage Vmeasured of the battery cell B1 falls in the rest section after charging occurs. FIG. 7A shows the actual voltage Vmeasured and the fitting value yfit of the battery cell B1. In FIG. 7A, the horizontal axis represents time (hours), and the vertical axis represents voltage (V). When no error occurs in the battery cell B1, as described with reference to FIG. 4A, the voltage Vmeasured of the battery cell B1 is gradually decreased and maintained at a specific voltage value. In this case, the specific voltage value may be slightly lower than the voltage at the time point when the charging is completed. On the other hand, when an error occurs in the battery cell B1, as shown in FIG. 7A, a peak section in which the voltage of the battery cell B1 temporarily decreases may occur.

FIG. 7B illustrates a case in which an abnormal voltage phenomenon in which the voltage Vmeasured of the battery cell B1 falls in the rest section after discharging occurs. FIG. 7B shows the actual voltage Vmeasured and the fitting value yfit of the battery cell B1. In FIG. 7B, the horizontal axis represents time (hours), and the vertical axis represents voltage (V). When no error occurs in the battery cell B1, as described with reference to FIG. 4B, the voltage Vmeasured of the battery cell B1 is gradually increased and maintained at a specific voltage value. In this case, the specific voltage value may be slightly lower than the voltage at the time point when the discharging is completed. On the other hand, when an error occurs in the battery cell B1, as shown in FIG. 7B, a peak section in which the voltage of the battery cell B1 temporarily decreases may occur.

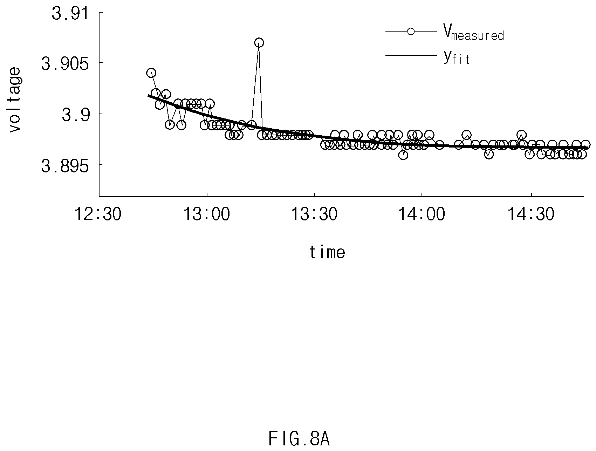

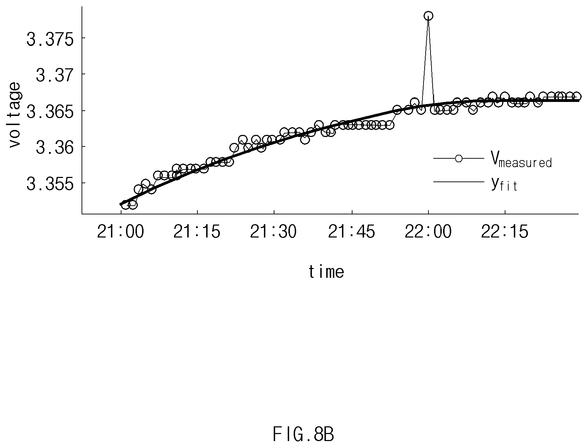

FIG. 8A is a graph illustrating a case in which the voltage of the battery cell B1 increases in the rest section after charging. FIG. 8B is a graph illustrating a case in which the voltage of the battery cell B1 increases in the rest section after discharging. For convenience of description, FIGS. 8A and 8B are referred to together.

FIG. 8A illustrates a case in which an abnormal voltage phenomenon in which the voltage Vmeasured of the battery cell B1 rises occurs in the rest section after charging. FIG. 8A shows the actual voltage Vmeasured and the fitting value yfit of the battery cell B1. In FIG. 8A, the horizontal axis represents time (hours), and the vertical axis represents voltage (V). When no error occurs in the battery cell B1, as described with reference to FIG. 4A, the voltage Vmeasured of the battery cell B1 is gradually decreased and maintained at a specific voltage value. On the other hand, when an error occurs in the battery cell B1, as shown in FIG. 8A, a peak section in which the voltage of the battery cell B1 temporarily increases may occur.

FIG. 8B illustrates a case in which an abnormal voltage phenomenon in which the voltage Vmeasured of the battery cell B1 rises occurs in the rest section after discharging. FIG. 8B shows the actual voltage Vmeasured and the fitting value yfit of the battery cell B1. In FIG. 8B, the horizontal axis represents time (hours), and the vertical axis represents voltage (V). When no error occurs in the battery cell B1, as described with reference to FIG. 4B, the voltage Vmeasured of the battery cell B1 is gradually increased and maintained at a specific voltage value. On the other hand, when an error occurs in the battery cell B1, as shown in FIG. 8B, a peak section in which the voltage of the battery cell B1 temporarily increases may occur.

FIG. 9A is a graph illustrating a case in which the battery cell B1 is unstable in the rest section after charging. FIG. 9B is a graph showing a case in which the battery cell B1 is unstable in the rest section after discharging. For convenience of description, FIGS. 9A and 9B are referred to together.

FIG. 9A illustrates a case in which an unstable abnormal voltage phenomenon occurs in the battery cell B1 in the rest section after charging. FIG. 9A shows the actual voltage Vmeasured and the fitting value yfit of the battery cell B1. In FIG. 9A, the horizontal axis represents time (hours), and the vertical axis represents voltage (V). When no error occurs in the battery cell B1, as described with reference to FIG. 4A, the voltage Vmeasured of the battery cell B1 is gradually decreased and maintained at a specific voltage value. On the other hand, when the battery cell B1 is unstable, as shown in FIG. 9A, a section in which the voltage of the battery cell B1 more continuously decreases may occur. When the battery cell B1 is unstable, the voltage of the battery cell B1 may decrease for a longer section of time than shown in FIGS. 7A and 8A.

FIG. 9B illustrates a case in which an unstable abnormal voltage phenomenon occurs in the battery cell B1 in the rest section after discharging. FIG. 9B shows the actual voltage Vmeasured and the fitting value yfit of the battery cell B1. In FIG. 9B, the horizontal axis represents time (hours), and the vertical axis represents voltage (V). When no error occurs in the battery cell B1, as described with reference to FIG. 4B, the voltage Vmeasured of the battery cell B1 is gradually increased and maintained at a specific voltage value. On the other hand, when the battery cell B1 is unstable, as shown in FIG. 9B, a section in which the voltage of the battery cell B1 more continuously increases may occur. When the battery cell B1 is unstable, the voltage of the battery cell B1 may increase for a longer section of time than shown in FIGS. 7A and 8A.

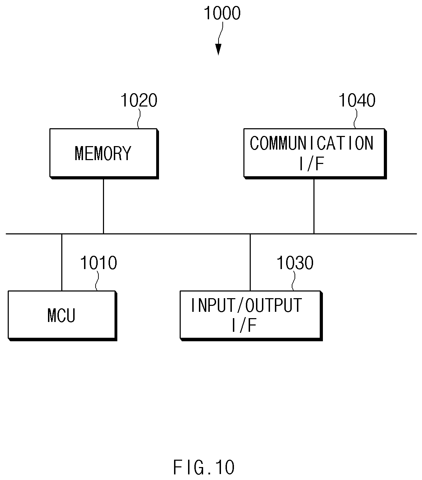

FIG. 10 is a diagram illustrating a hardware configuration of a battery diagnosis device according to an embodiment of the present invention.

Referring to FIG. 10, a battery diagnosis device 1000 may include a microcontroller (MCU) 1010 for controlling various processes and each configuration, a memory 1020 on which an operating system program and various programs (e.g., a battery diagnosis program, a voltage fitting equation calculation program, etc.) are recorded, an input/output interface 1030 for providing an input interface and an output interface between the battery cell module and/or the semiconductor switching element, and a communication interface 1040 capable of communicating with the outside through a wired/wireless communication network. In this way, the computer program according to the present invention may be recorded in the memory 1020 and processed by the microcontroller 1010, and for example, may be implemented as a module that performs each functional block shown in FIG. 2.

The above are specific embodiments for carrying out the present invention. The present invention will include not only the above-described embodiments, but also simple design changes or easily changeable embodiments. In addition, the present invention will include techniques that can be easily modified and implemented using the embodiments. Therefore, the scope of the present invention should not be limited to the above-described embodiments, but should be defined by the claims described below.

## Claims

1. A battery diagnosis device (200) comprising:

   a voltage measurement circuit (210) configured to periodically measure voltages at both ends of a battery cell (B1..BN) in a plurality of rest sections;
   a data processing circuit (220) configured to derive a statistical value indicating a state of the battery cell (B1..BN) based on difference values between voltage values measured by the voltage measurement circuit (210) and fitting values calculated based on the measured voltage values for each rest section; and
   a diagnosis circuit (230) configured to determine whether an error has occurred in the battery cell (B1..BN) based on the statistical values in the plurality of rest sections, and determine whether the type of error is a first type in which the battery cell (B1..BN) is unstable, a second type in which the voltage of the battery cell (B1..BN) temporarily rises, or a third type in which the voltage of the battery cell (B1..BN) temporarily drops based on a cumulative statistical value in which absolute values of the statistical values are accumulated and the statistical value in the rest section,
   wherein the plurality of rest sections comprise the rest section and one or more rest sections before the rest section.

2. The battery diagnosis device (200) of claim 1, wherein each of the plurality of rest sections is a section from after charging the battery cell (B1..BN) is completed to before starting discharging or a section from after discharging the battery cell (B1..BN) is completed to before charging is started.

3. The battery diagnosis device (200) of claim 1, wherein the data processing circuit (220) determines 'a', 'b' and 'c' of Equation using the measured voltage values, derives a fitting value '$y_{fit}$' using Equation, derives the fitting values by inputting times at which the measured voltage values are measured in Equation, and determines as the statistical value one of the difference values between the measured voltage values and the fitting values corresponding to the measured voltage values,
   wherein the statistical value is a difference value with the largest absolute value among the difference values.

   (Equation)
   $$y_{fit} = a \times \exp(b \cdot t) + c$$

4. The battery diagnosis device (200) of claim 1, wherein the diagnosis circuit (230) determines that the type of error is the first type if the cumulative statistical value is greater than a first analysis reference value, determines that the type of error is the second type when the cumulative statistical value is less than the first analysis reference value and the statistical value is greater than a second analysis reference value, and determines that the type of error is the third type when the cumulative statistical value is less than the first analysis reference value and the statistical value is less than the second analysis reference value.

5. The battery diagnosis device (200) of claim 4, wherein the first analysis reference value is a value related to the voltage in the rest section,
   wherein the second analysis reference value is '0'.

6. The battery diagnosis device (200) of claim 1, wherein if the type of error is the first type, the voltage in the rest section increases for a longer time section than when the type of error is the second type or decreases for a longer time section than when the type of error is the third type.

7. The battery diagnosis device (200) of claim 1, wherein the diagnosis circuit (230) determines whether the error has occurred in the battery cell (B1..BN) based on the accumulated statistical value when the absolute value of the statistical value is greater than a first absolute reference value and less than or equal to a second absolute reference value, determines that an error more fatal than the error has occurred in the battery cell (B1..BN) when the absolute value is greater than the second absolute reference value, and determines that an error does not occur in the battery cell (B1..BN) when the absolute value is less than the first absolute reference value.

8. The battery diagnosis device (200) of claim 7, wherein the first absolute reference value is a value related to an error tolerance range of the absolute value,
   wherein the second absolute reference value is a value related to the fatal error.

9. The battery diagnosis device (200) of claim 1, wherein the data processing circuit (220) calculates a relative reference value based on the statistical values of the battery cells (B1..BN), wherein the diagnosis circuit (230) determines whether the error has occurred in the battery cell (B1..BN) based on the cumulative statistical value when the absolute value of the statistical value is greater than the relative reference value, and determines that no error has occurred in the battery cell (B1..BN) when the absolute value of the statistical value is less than the relative reference value,
   wherein the battery cells (B1..BN) are battery cells (B1..BN) of a battery module (100) including the battery cell (B1..BN).

10. The battery diagnosis device (200) of claim 9, wherein the data processing circuit (220) sets an 'n' sigma value of the statistical values of the battery cells as the relative reference value,
where 'n' is a positive number.

11. The battery diagnosis device (200) of claim 1, wherein the data processing circuit (220) calculates a standard deviation value of the statistical values in the plurality of rest sections,
wherein the diagnosis circuit (230) determines whether the error has occurred in the battery cell (B1..BN) based on the statistical value when the standard deviation value is greater than the reference deviation value and the cumulative statistical value is greater than a cumulative reference value, and determines that an error does not occur in the battery cell (B1..BN) when the standard deviation value is less than the reference deviation value or the cumulative statistical value is less than the cumulative reference value.

12. The battery diagnosis device (200) of claim 11, wherein the cumulative reference value is a value corresponding to the top 'm'% of the cumulative statistic values in which absolute values of the statistic values of battery cells (B1..BN) are accumulated, where 'm' is a positive number.

13. A battery diagnosing method comprising:

a first step of periodically measuring (S110) a voltage at both ends of a battery cell (B1..BN) in a plurality of rest sections by a battery diagnosis device;
a second step of calculating (S130) a statistical value representing a state of the battery cell (B1..BN) based on difference values between voltage values measured by the battery diagnosis device and fitting values calculated based on the measured voltage values for each rest section;
a third step of determining (S150) whether an error has occurred in the battery cell (B1..BN) based on the statistical values in the plurality of rest sections; and
a fourth step of diagnosing (S160) the type of error based on a first comparison result of comparing a cumulative statistical value accumulated with absolute values of the statistical values with a first analysis reference value, and a second comparison result of comparing the statistical value with a second analysis reference value,
wherein the plurality of rest sections comprise the rest section and one or more rest sections before the rest section.

14. The method of claim 13, wherein the fourth step (S160) determines that the type of error is a first type in which the battery cell (B1..BN) is unstable when the cumulative statistical value is greater than the first analysis reference value, determines that the type of error is a second type in which the voltage of the battery cell (B1..BN) temporarily rises when the cumulative statistical value is less than the first analysis reference value and the statistical value is greater than the second analysis reference value, and determines that the type of error is a third type in which the voltage of the battery cell (B1..BN) temporarily drops when the cumulative statistical value is less than the first analysis reference value and the statistical value is less than the second analysis reference value.

15. The method of claim 14, wherein the first analysis reference value is a value related to the voltage in the rest section,
wherein the second analysis reference value is '0'.

**Patentansprüche**

1. Batteriediagnosevorrichtung (200), umfassend:

eine Spannungsmessschaltung (210), welche dazu eingerichtet ist, Spannungen an beiden Enden einer Batteriezelle (B1..BN) in einer Mehrzahl von Ruheabschnitten periodisch zu messen;
eine Datenverarbeitungsschaltung (220), welche dazu eingerichtet ist, einen statistischen Wert abzuleiten, welcher einen Zustand der Batteriezelle (B1..BN) anzeigt, auf Grundlage von Differenzwerten zwischen Spannungswerten, welche durch die Spannungsmessschaltung (210) gemessen werden, und Fittingwerten, welche auf Grundlage der gemessenen Spannungswerte für jeden Ruheabschnitt berechnet werden; und
eine Diagnoseschaltung (230), welche dazu eingerichtet ist, zu bestimmen, ob ein Fehler in der Batteriezelle (B1..BN) aufgetreten ist, auf Grundlage der statistischen Werte in der Mehrzahl von Ruheabschnitten, und zu bestimmen, ob die Art des Fehlers eine erste Art, in welcher die Batteriezelle (B1..BN) instabil ist, eine zweite Art, in welcher die Spannung der Batteriezelle (B1..BN) temporär ansteigt, oder eine dritte Art ist, in welcher die Spannung der Batteriezelle (B1..BN) temporär abfällt, auf Grundlage eines kumulativen statistischen Werts, in welchem absolute Werte der statistischen Werte akkumuliert sind, und des statistischen Werts in dem Ruheabschnitt,
wobei die Mehrzahl von Ruheabschnitten den Ruheabschnitt und einen oder mehrere Ruheabschnitte vor dem Ruheabschnitt umfasst.

2. Batteriediagnosevorrichtung (200) nach Anspruch 1, wobei jeder aus der Mehrzahl von Ruheabschnitten ein Abschnitt von nachdem ein Laden der Batteriezelle (B1..BN) abgeschlossen ist bis vor einem Starten eines Entladens oder ein Abschnitt ist von nachdem ein Entladen der Batteriezelle (B1..BN) abgeschlossen ist bis bevor ein Laden gestartet ist.

3. Batteriediagnosevorrichtung (200) nach Anspruch 1, wobei die Datenverarbeitungsschaltung (220) 'a', 'b', und 'c' von Gleichung bestimmt, unter Verwendung der gemessenen Spannungswerte, einen Fittingwert '$y_{fit}$' unter Verwendung von Gleichung ableitet, die Fittingwerte durch Eingeben von Zeiten, zu welchen die die gemessenen Spannungswerte in Gleichung gemessen werden, ableitet und als den statistischen Wert einen der Differenzwerte zwischen den gemessenen Spannungswerten und den Fittingwerten, welche den gemessenen Spannungswerten entsprechen, bestimmt, wobei der statistische Wert ein Differenzwert mit dem größten absoluten Wert unter den Differenzwerten ist.

(Gleichung)

$$y_{fit} = a \times exp(b \cdot t) + c$$

4. Batteriediagnosevorrichtung (200) nach Anspruch 1, wobei die Diagnoseschaltung (230) bestimmt, dass die Art des Fehlers die erste Art ist, falls der kumulative statistische Wert größer als ein erster Analysereferenzwert ist, bestimmt, dass die Art des Fehlers die zweite Art ist, wenn der kumulative statistische Wert kleiner als der erste Analysereferenzwert ist und der statistische Wert größer als ein zweiter Analysereferenzwert ist, und bestimmt, dass die Art des Fehlers die dritte Art ist, wenn der kumulative statistische Wert kleiner als der erste Analysereferenzwert ist und der statistische Wert kleiner als der zweite Analysereferenzwert ist.

5. Batteriediagnosevorrichtung (200) nach Anspruch 4, wobei der erste Analysereferenzwert ein Wert ist, welcher die Spannung in dem Ruhabschnitt betrifft, wobei der zweite Analysereferenzwert '0' ist.

6. Batteriediagnosevorrichtung (200) nach Anspruch 1, wobei, falls die Art des Fehlers die erste Art ist, die Spannung in dem Ruheabschnitt für einen längeren Zeitabschnitt ansteigt, als wenn die Art des Fehlers die zweite Art ist, oder für einen längeren Zeitabschnitt abfällt, als wenn die Art des Fehlers die dritte Art ist.

7. Batteriediagnosevorrichtung (200) nach Anspruch 1, wobei die Diagnoseschaltung (230) bestimmt, ob der Fehler in der Batteriezelle (B1..BN) aufgetreten ist, auf Grundlage des akkumulierten statistischen Werts, wenn der absolute Wert des statistischen Werts größer als ein erster absoluter Referenzwert und kleiner als oder gleich einem zweiten absoluten Referenzwert ist, bestimmt, dass ein Fehler fatalerer als der Fehler in der Batteriezelle (B1..BN) aufgetreten ist, wenn der absolute Wert größer als der zweite absolute Referenzwert ist, und bestimmt, dass ein Fehler in der Batteriezelle (B1..BN) nicht auftritt, wenn der absolute Wert kleiner als der erste absolute Referenzwert ist.

8. Batteriediagnosevorrichtung (200) nach Anspruch 7, wobei der erste absolute Referenzwert ein Wert ist, welcher einen Fehlertoleranzbereich des absoluten Werts betrifft, wobei der zweite absolute Referenzwert ein Wert ist, welcher den fatalen Fehler betrifft.

9. Batteriediagnosevorrichtung (200) nach Anspruch 1, wobei die Datenverarbeitungsschaltung (220) einen relativen Referenzwert auf Grundlage der statistischen Werte der Batteriezellen (B1..BN) berechnet, wobei die Diagnoseschaltung (230) bestimmt, ob der Fehler in der Batteriezelle (B1..BN) aufgetreten ist, auf Grundlage des kumulativen statistischen Werts, wenn der absolute Wert des statistischen Werts größer als der relative Referenzwert ist, und bestimmt, dass kein Fehler in der Batteriezelle (B1..BN) aufgetreten ist, wenn der absolute Wert des statistischen Werts kleiner als der relative Referenzwert ist, wobei die Batteriezellen (B1..BN) Batteriezellen (B1..BN) eines Batteriemoduls (100) sind, welches die Batteriezelle (B1..BN) umfasst.

10. Batteriediagnosevorrichtung (200) nach Anspruch 9, wobei die Datenverarbeitungsschaltung (220) einen 'n' Sigma-Wert der statistischen Werte der Batteriezellen als den relativen Referenzwert festlegt, wobei 'n' eine positive Zahl ist.

11. Batteriediagnosevorrichtung (200) nach Anspruch 1, wobei die Datenverarbeitungsschaltung (220) einen Standardabweichungswert der statistischen Werte in der Mehrzahl der Ruheabschnitte berechnet, wobei die Diagnoseschaltung (230) bestimmt, ob der Fehler in der Batteriezelle (B1..BN) aufgetreten ist, auf Grundlage des statistischen Werts, wenn der Standardabweichungswert größer als der Referenzabweichungswert ist und der kumulative statistische Wert größer als ein kumulativer Referenzwert ist, und bestimmt, dass ein Fehler in der Batteriezelle (B1..BN) nicht auftritt, wenn der Standardabweichungswert kleiner als der Referenzabweichungswert ist oder der kumulative statistische Wert kleiner als der kumulative Referenzwert ist.

**12.** Batteriediagnosevorrichtung (200) nach Anspruch 11, wobei der kumulative Referenzwert ein Wert ist, welcher den oberen 'm' % der kumulativen statistischen Werte entspricht, in welchen absolute Werte der statistischen Werte von Batteriezellen (B1..BN) akkumuliert sind, wobei 'm' eine positive Zahl ist.

**13.** Batteriediagnoseverfahren, umfassend:

einen ersten Schritt eines periodischen Messens (S110) einer Spannung an beiden Enden einer Batteriezelle (B1..BN) in einer Mehrzahl von Ruheabschnitten durch eine Batteriediagnosevorrichtung; einen zweiten Schritt eines Berechnens (S130) eines statistischen Werts, welcher einen Zustand der Batteriezelle (B1..BN) repräsentiert, auf Grundlage von Differenzwerten zwischen Spannungswerten, welche durch die Batteriediagnosevorrichtung gemessen werden, und Fittingwerten, welche auf Grundlage der gemessenen Spannungswerte für jeden Ruheabschnitt berechnet werden; einen dritten Schritt eines Bestimmens (S150), ob ein Fehler in der Batteriezelle (B1..BN) aufgetreten ist, auf Grundlage der statistischen Werte in der Mehrzahl von Ruheabschnitten; und einen vierten Schritt eines Diagnostizierens (S160) der Art des Fehlers, auf Grundlage eines ersten Vergleichsergebnisses eines Vergleichens eines kumulativen statistischen Werts, welcher mit absoluten Werten der statistischen Werte akkumuliert ist, mit einem ersten Analysereferenzwert und eines zweiten Vergleichsergebnisses eines Vergleichens des statistischen Werts mit einem zweiten Analysereferenzwert, wobei die Mehrzahl von Ruheabschnitten den Ruheabschnitt und einen oder mehrere Ruheabschnitte vor dem Ruheabschnitt umfasst.

**14.** Verfahren nach Anspruch 13, wobei der vierte Schritt (S160) bestimmt, dass die Art des Fehlers eine erste Art ist, in welcher die Batteriezelle (B1..BN) instabil ist, wenn der kumulative statistische Wert größer als der erste Analysereferenzwert ist, bestimmt, dass die Art des Fehlers eine zweite Art ist, in welcher die Spannung der Batteriezelle (B1..BN) temporär ansteigt, wenn der kumulative statistische Wert kleiner als der erste Analysereferenzwert ist und der statistische Wert größer als der zweite Analysereferenzwert ist, und bestimmt, dass die Art des Fehlers eine dritte Art ist, in welcher die Spannung der Batteriezelle (B1..BN) temporär abfällt, wenn der kumulative statistische Wert kleiner als der erste Analysereferenzwert ist und der statistische Wert kleiner als der zweite Analysereferenzwert ist.

**15.** Verfahren nach Anspruch 14, wobei der erste Analysereferenzwert ein Wert ist, welcher die Spannung in dem Ruheabschnitt betrifft, wobei der zweite Analysereferenzwert '0' ist.

## Revendications

**1.** Dispositif de diagnostic de batterie (200) comprenant :

un circuit de mesure de tension (210) configuré pour mesurer périodiquement des tensions aux deux extrémités d'un élément de batterie (B1..BN) dans une pluralité de sections de repos ; un circuit de traitement de données (220) configuré pour dériver une valeur statistique indiquant un état de l'élément de batterie (B1..BN) sur la base de valeurs de différence entre des valeurs de tension mesurées par le circuit de mesure de tension (210) et des valeurs d'ajustement calculées sur la base des valeurs de tension mesurées pour chaque section de repos ; et un circuit de diagnostic (230) configuré pour déterminer si une erreur s'est produite dans l'élément de batterie (B1..BN) sur la base des valeurs statistiques dans la pluralité de sections de repos, et déterminer si le type d'erreur est un premier type dans lequel l'élément de batterie (B1..BN) est instable, un deuxième type dans lequel la tension de l'élément de batterie (B1..BN) augmente temporairement, ou un troisième type dans lequel la tension de l'élément de batterie (B1..BN) chute temporairement sur la base d'une valeur statistique cumulée dans laquelle sont cumulées les valeurs absolues des valeurs statistiques et la valeur statistique dans la section de repos, dans lequel la pluralité de sections de repos comprend la section de repos et une ou plusieurs sections de repos avant la section de repos.

**2.** Dispositif de diagnostic de batterie (200) selon la revendication 1, dans lequel chacune de la pluralité de sections de repos est une section allant de la fin de la charge de l'élément de batterie (B1..BN) jusqu'au début de la décharge ou une section allant de la fin de la décharge de l'élément de batterie (B1..BN) jusqu'au début de la charge.

3.  Dispositif de diagnostic de batterie (200) selon la revendication 1, dans lequel le circuit de traitement de données (220) détermine « a », « b » et « c » de l'équation à l'aide des valeurs de tension mesurées, déduit une valeur d'ajustement « y $_{fit}$ » à l'aide de l'équation, déduit les valeurs d'ajustement en entrant les temps auxquels les valeurs de tension mesurées sont mesurées dans l'équation, et détermine comme valeur statistique l'une des valeurs de différence entre les valeurs de tension mesurées et les valeurs d'ajustement correspondant aux valeurs de tension mesurées.

    dans lequel la valeur statistique est une valeur de différence avec la plus grande valeur absolue parmi les valeurs de différence.

    (Équation)

    $$y_{fit} = a \times \exp(b \cdot t) + c$$

4.  Dispositif de diagnostic de batterie (200) selon la revendication 1, dans lequel le circuit de diagnostic (230) détermine que le type d'erreur est le premier type si la valeur statistique cumulée est supérieure à une première valeur de référence d'analyse, détermine que le type d'erreur est le deuxième type lorsque la valeur statistique cumulée est inférieure à la première valeur de référence d'analyse et la valeur statistique est supérieure à une seconde valeur de référence d'analyse, et détermine que le type d'erreur est le troisième type lorsque la valeur statistique cumulée est inférieure à la première valeur de référence d'analyse et que la valeur statistique est inférieure à la seconde valeur de référence d'analyse.

5.  Dispositif de diagnostic de batterie (200) selon la revendication 4, dans lequel la première valeur de référence d'analyse est une valeur liée à la tension dans la section de repos,

    dans lequel la seconde valeur de référence d'analyse est « 0 ».

6.  Dispositif de diagnostic de batterie (200) selon la revendication 1, dans lequel si le type d'erreur est le premier type, la tension dans la section de repos augmente pendant une section de temps plus longue que lorsque le type d'erreur est le deuxième type ou diminue pendant une section de temps plus longue que lorsque le type d'erreur est le troisième type.

7.  Dispositif de diagnostic de batterie (200) selon la revendication 1, dans lequel le circuit de diagnostic (230) détermine si l'erreur s'est produite dans l'élément de batterie (B1..BN) sur la base de la valeur statistique accumulée lorsque la valeur absolue de la valeur statistique est supérieure à une première valeur absolue de référence et inférieure ou égale à une seconde valeur de référence absolue, détermine qu'une erreur plus fatale que l'erreur s'est produite dans l'élément de batterie (B1..BN) lorsque la valeur absolue est supérieure à la seconde valeur absolue de référence, et détermine qu'une erreur ne se produit pas dans l'élément de batterie (B 1..BN) lorsque la valeur absolue est inférieure à la première valeur absolue de référence.

8.  Dispositif de diagnostic de batterie (200) selon la revendication 7, dans lequel la première valeur absolue de référence est une valeur liée à une plage de tolérance d'erreur de la valeur absolue,

    dans lequel la seconde valeur absolue de référence est une valeur liée à l'erreur fatale.

9.  Dispositif de diagnostic de batterie (200) selon la revendication 1, dans lequel le circuit de traitement de données (220) calcule une valeur de référence relative sur la base des valeurs statistiques des éléments de batterie (B1..BN), dans lequel le circuit de diagnostic (230) détermine si l'erreur s'est produite dans l'élément de batterie (B1..BN) sur la base de la valeur statistique cumulée lorsque la valeur absolue de la valeur statistique est supérieure à la valeur de référence relative, et détermine qu'aucune erreur ne s'est produite dans l'élément de batterie (B1..BN) lorsque la valeur absolue de la valeur statistique est inférieure à la valeur de référence relative,

    dans lequel les éléments de batterie (B1..BN) sont des éléments de batterie (B1..BN) d'un module de batterie (100) comportant l'élément de batterie (B1..BN).

10. Dispositif de diagnostic de batterie (200) selon la revendication 9, dans lequel le circuit de traitement de données (220) définit une valeur « n » sigma des valeurs statistiques des éléments de batterie comme valeur de référence relative,

    où « n » est un nombre positif.

11. Dispositif de diagnostic de batterie (200) selon la revendication 1, dans lequel le circuit de traitement de données (220) calcule une valeur d'écart-type des valeurs statistiques dans la pluralité de sections de repos,

    dans lequel le circuit de diagnostic (230) détermine si l'erreur s'est produite dans l'élément de batterie (B1..BN) sur la base de la valeur statistique lorsque la valeur d'écart-type est supérieure à la valeur d'écart de référence et la valeur statistique cumulée est supérieure à la valeur de référence cumulée, et détermine qu'une erreur ne se produit pas dans l'élément de batterie (B1..BN) lorsque la valeur d'écart type est inférieure à la valeur d'écart de référence ou que la valeur statistique cumulée est inférieure à la valeur de référence cumulée.

12. Dispositif de diagnostic de batterie (200) selon la revendication 11, dans lequel la valeur de référence cumulée est une valeur correspondant au « m » % supérieur des valeurs statistiques cumulées dans lesquelles des valeurs absolues des valeurs statistiques des éléments de batterie (B1..BN) sont accumulées, où « m » est un nombre positif.

13. Procédé de diagnostic de batterie, comprenant :

une première étape de mesure périodique (S110) d'une tension aux deux extrémités d'un élément de batterie (B1..BN) dans une pluralité de sections de repos par un dispositif de diagnostic de batterie ;
une deuxième étape de calcul (S130) d'une valeur statistique représentant un état de l'élément de batterie (B1..BN) sur la base de valeurs de différence entre des valeurs de tension mesurées par le dispositif de diagnostic de batterie et des valeurs d'ajustement calculées sur la base des valeurs de tension mesurées pour chaque section de repos ;
une troisième étape de détermination (S150) si une erreur s'est produite dans l'élément de batterie (B1..BN) sur la base des valeurs statistiques dans la pluralité de sections de repos ; et
une quatrième étape de diagnostic (S160) du type d'erreur sur la base d'un premier résultat de comparaison de la comparaison d'une valeur statistique cumulée accumulée avec des valeurs absolues des valeurs statistiques avec une première valeur de référence d'analyse, et d'un second résultat de comparaison de la comparaison de la valeur statistique avec une seconde valeur de référence d'analyse,
dans lequel la pluralité de sections de repos comprend la section de repos et une ou plusieurs sections de repos avant la section de repos.

14. Procédé selon la revendication 13, dans lequel la quatrième étape (S160) détermine que le type d'erreur est un premier type dans lequel l'élément de batterie (B1..BN) est instable lorsque la valeur statistique cumulée est supérieure à la première valeur de référence d'analyse, détermine que le type d'erreur est un deuxième type dans lequel la tension de l'élément de batterie (B1..BN) augmente temporairement lorsque la valeur statistique cumulée est inférieure à la première valeur de référence d'analyse et que la valeur statistique est supérieure à la seconde valeur de référence d'analyse, et détermine que le type d'erreur est un troisième type dans lequel la tension de l'élément de batterie (B1..BN) chute temporairement lorsque la valeur statistique cumulée est inférieure à la première valeur de référence d'analyse et que la valeur statistique est inférieure à la seconde valeur de référence d'analyse.

15. Procédé selon la revendication 14, dans lequel la première valeur de référence d'analyse est une valeur liée à la tension dans la section de repos,
dans lequel la seconde valeur de référence d'analyse est « 0 ».

FIG.1

FIG.2

START

PERIODICALLY MEASURE VOLTAGE OF BATTERY CELL B1 IN REST SECTION — S110

CALCULATE FITTING VALUE $y_{fit}$ BASED ON FITTING EQUATION CALCULATED BASED ON MEASURED VOLTAGE VALUES $V_1$ TO $V_n$ — S120

CALCULATE STATISTICAL VALUE max $(|V_1 - y_{fit}|, \ldots, |V_n - y_{fit}|)$ — S130

STORE STATISTICAL VALUE FOR EACH RESET SECTION — S140

DIAGNOSE WHETHER ABNORMAL VOLTAGE PHENOMENON HAS OCCURRED BASED ON STATISTICAL VALUE — S150

DIAGNOSE TYPE OF ABNORMAL VOLTAGE PHENOMENON BASED ON STATISTICAL VALUE — S160

END

FIG.3

FIG.4A

FIG.4B

```
                            ┌─────────┐
                            │  START  │
                            └────┬────┘
                                 │
                    ┌────────────▼────────────┐
                    │   STORE STATISTICAL     │
                    │   VALUE FOR EACH        │──── S140
                    │   REST SECTION          │
                    └────────────┬────────────┘
                                 │
              S151               │                              S155
         ┌─────────────────────────────┐            ┌──────────────────────────┐
         │     FIRST ABSOLUTE          │            │    SECOND ABSOLUTE       │  YES
         │ REFERENCE VALUE < ABSOLUTE  │    NO      │ REFERENCE VALUE < ABSOLUTE│───────┐
         │ STATISTICAL VALUE =< SECOND │──────────► │   STATISTICAL VALUE?     │       │
         │   ABSOLUTE REFERENCE        │            └──────────────┬───────────┘       │
         │        VALUE?               │                          │ NO                │
         └─────────────┬───────────────┘                          │                   │
                       │ YES                                       │                   │
              S152     │                                           │                   │
         ┌─────────────────────────────┐                          │                   │
         │      ABSOLUTE               │    NO                     │                   │
         │ STATISTICAL VALUE > RELATIVE │──────────┐               │                   │
         │    REFERENCE VALUE?         │          │               │                   │
         └─────────────┬───────────────┘          │               │                   │
                       │ YES                       │               │                   │
              S153     │                           │               │                   │
         ┌─────────────────────────────┐           │               │                   │
         │      NUMBER OF              │           │               │                   │
         │    DIAGNOSIS > 1,          │    NO      │               │                   │
         │ STANDARD DEVIATION VALUE   │────────┐   │               │                   │
         │ > REFERENCE DEVIATION VALUE │        │   │               │                   │
         │ AND CUMULATIVE STATISTICAL  │        │   │               │                   │
         │  VALUE > CUMULATIVE        │        │   │               │                   │
         │      REFERENCE             │        │   │               │                   │
         │       VALUE?               │        │   │               │                   │
         └─────────────┬───────────────┘        │   │               │                   │
                       │ YES      S154           │   │      S156     │          S157     │
         ┌─────────────▼───────────────┐   ┌─────▼───▼──────────┐  ┌─────────────▼─────┐
         │ DETERMINE THAT ABNORMAL     │   │ DETERMINE THAT     │  │ DETERMINE THAT    │
         │ VOLTAGE PHENOMENON OCCURS    │   │ BATTERY CELL B1    │  │ FIRE OCCURS       │
         │ IN BATTERY CELL B1          │   │ IS NORMAL          │  │ IN BATTERY CELL B1│
         └─────────────┬───────────────┘   └─────────┬──────────┘  └─────────┬─────────┘
                       │                             │                       │
         ┌─────────────▼───────────────┐             │                       │
         │ DIAGNOSE TYPE OF ABNORMAL   │             │                       │
         │ VOLTAGE PHENOMENON BASED ON │──── S160     │                       │
         │   STATISTICAL VALUE         │             │                       │
         └─────────────┬───────────────┘             │                       │
                       │                             │                       │
                       └──────────────┬──────────────┴───────────────────────┘
                                      │
                                 ┌────▼────┐
                                 │   END   │
                                 └─────────┘
```

FIG.5

EP 4 137 829 B1

START

DETERMINE THAT ABNORMAL
VOLTAGE PHENOMENON OCCURS
IN BATTERY CELL B1 — S154

CUMULATIVE
STATISTICAL VALUE >
FIRST ANALYSIS
REFERENCE VALUE? — S161

NO

ACTUAL
STATISTICAL VALUE >
SECOND ANALYSIS
REFERENCE VALUE? — S163

NO

YES

DETERMINE THAT BATTERY
CELL B1 IS UNSTABLE — S162

S164 — DETERMINE THAT VOLTAGE OF
BATTERY CELL B1 INCREASES

YES

DETERMINE THAT VOLTAGE OF
BATTERY CELL B1 DECREASES — S165

END

FIG.6

FIG.7A

FIG.7B

FIG.8A

FIG.8B

FIG.9A

FIG.9B

1000

1020

MEMORY

1040

COMMUNICATION
I/F

1010

MCU

1030

INPUT/OUTPUT
I/F

FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020200091936
- US 2020191876 A1